(19) Europäisches Patentamt
European Patent Office
Office européen des brevets

(11) **EP 4 492 592 B1**

(12) **EUROPEAN PATENT SPECIFICATION**

(45) Date of publication and mention
of the grant of the patent:
**28.01.2026 Bulletin 2026/05**

(21) Application number: **24186042.8**

(22) Date of filing: **02.07.2024**

(51) International Patent Classification (IPC):
*H01S 5/028* (2006.01)   *H01S 5/14* (2006.01)
*H01S 5/323* (2006.01)

(52) Cooperative Patent Classification (CPC):
**H01S 5/0282; H01S 5/0287; H01S 5/32325;**
H01S 5/141

(54) **SEMICONDUCTOR LIGHT-EMITTING ELEMENT AND EXTERNAL RESONATOR TYPE LASER MODULE**

LICHTEMITTIERENDES HALBLEITERELEMENT UND LASERMODUL MIT EXTERNEM RESONATOR

ÉLÉMENT ÉLECTROLUMINESCENT À SEMI-CONDUCTEUR ET MODULE LASER DE TYPE RÉSONATEUR EXTERNE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **10.07.2023 JP 2023113226**

(43) Date of publication of application:
**15.01.2025 Bulletin 2025/03**

(73) Proprietor: **Ushio Denki Kabushiki Kaisha Tokyo 100-8150 (JP)**

(72) Inventors:
• **WATANABE, Kyohei**
**Tokyo 100-8150 (JP)**
• **HAGIMOTO, Masato**
**Tokyo 100-8150 (JP)**

(74) Representative: **Maiwald GmbH**
**Engineering**
**Elisenhof**
**Elisenstrasse 3**
**80335 München (DE)**

(56) References cited:
**US-A1- 2005 127 383     US-A1- 2009 086 782**
**US-A1- 2010 316 082**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

BACKGROUND OF THE INVENTION

1. Field of the Invention

The present disclosure relates to a semiconductor light-emitting element used for an external resonator type semiconductor laser.

2. Description of the Related Art

In recent years, external resonator type semiconductor lasers have been utilized. In the external resonator type semiconductor laser, a semiconductor laser element is used as a semiconductor light amplifying element, and a laser resonator is formed between a diffraction grating provided outside the semiconductor laser element and a rear end surface of the semiconductor laser. By installing a mirror so as to reflect only a specific wavelength by the diffraction grating, oscillation occurs only in a single longitudinal mode, and narrowing of a line width of emitted light is achieved.

As compared with a distributed feedback (DFB) laser or a distributed Bragg reflector (DBR) laser each having a diffraction grating structure in the semiconductor laser element, the mirror exists outside, and thus high output can be easily achieved. From such characteristics, the external resonator type semiconductor laser is applied to applications requiring light of a specific wavelength with high output, such as optical communication, optical measurement, and laser cooling.

In the external resonator type semiconductor laser as described above, antireflection film (AR) coating is applied to adjust reflectance of an emission side end surface of the semiconductor laser element functioning as the semiconductor light amplifying element. As the reflectance decreases, a loss as an external resonator is reduced, and thus the reflectance is required to be as close to 0% (about 0.01%) as possible. Specifically, the reflectance of 0.2% or less, preferably 0.1% or less is required at a desired wavelength.

Thus, the AR film is designed so that the reflectance is the lowest at the desired wavelength, but when the film thickness varies, the wavelength at which the reflectance is the lowest point shifts, and the reflectance at the desired wavelength increases.

Accuracy required for the film thickness of the AR film becomes more severe as an oscillation wavelength of the laser is shorter. In a case of a laser in a 600 nm band to a 700 nm band, film thickness control in the order of 1 nm or less is required to obtain a low reflection film having the reflectance of 0.1% or less, and it is very difficult to achieve the film thickness control by simply controlling a flow condition of a film formation material and film formation time. In order to solve such a problem, a method has been proposed (JP H6-125149 A) in which film formation is performed while measuring the reflectance in a state where laser oscillation is performed at a time of the film formation.

Patent Literature 1:JP H6-125149 A
Patent Literature 2: US 6,297,066
Patent Literature 3: JP H4-299591 A
Patent Literature 4: JP 4621791 B2

US 2005/127383 A1 discloses a semiconductor laser with an AlGaInP-based epitaxial layered structure on a GaAs substrate. An aluminum oxide film lacking in oxygen is formed adjacent to the semiconductor on an optical resonator facet as a low reflection film.

SUMMARY OF THE INVENTION

In a laser in a 600 nm band to a 700 nm band, an AlGaInP-based material is used as a semiconductor material. The AlGaInP-based material is chemically unstable as compared with a GaAs (AlGaAs)-based material. Specifically, the AlGaInP-based material is weak against degradation due to oxidation, and thus a film that can be used for AR coating is limited. In addition, in order to ensure long-term reliability of the laser, ingress of water needs to be prevented.

An aspect of the present disclosure has been made in view of such a problem, and one of its exemplary object is to provide a semiconductor light-emitting element including an AR film having long-term reliability and low reflectance.

A semiconductor light-emitting element according to the present invention includes a semiconductor substrate, an epitaxial layered structure formed on the semiconductor substrate, including an N-type cladding layer, an active layer, and a P-type cladding layer, and made of an AlGaInP-based material, and an anti-reflection (AR) film including a first layer containing $Al_2O_3$ formed on an emission side end surface of the epitaxial layered structure, and a second layer formed on the first layer. A rare gas element content of the first layer is larger than a rare gas element content of the second layer.

According to an aspect of the present disclosure, a semiconductor light-emitting element including an AR film having long-term reliability and low reflectance can be provided.

BRIEF DESCRIPTION OF THE DRAWINGS

Fig. 1 is a cross-sectional view of a semiconductor light-emitting element according to a first embodiment;
Fig. 2 is a diagram illustrating reflectance characteristics of an AR film according to the first embodiment;
Fig. 3 is a cross-sectional view of a semiconductor light-emitting element according to a second embodiment;

Fig. 4 is a diagram illustrating reflectance characteristics of an AR film according to the second embodiment;

Fig. 5 is a cross-sectional view of a semiconductor light-emitting element according to a third embodiment; and

Fig. 6 is a view illustrating an external resonator type laser module including a semiconductor light-emitting element.

## DETAILED DESCRIPTION OF THE INVENTION

### Outline of Embodiments

An outline of some exemplary embodiments of the present disclosure will be described. This outline is intended as a prelude to the detailed description that follows, or for a basic understanding of the embodiments. This outline describes some concepts of one or more embodiments in a simplified manner, and is not intended to limit the scope of the invention or disclosure. Also, this outline is not a comprehensive outline of all possible embodiments and is not intended to limit the essential components of the embodiments. For convenience, the term "one embodiment" may be used to refer to one embodiment (an example or a variation) or a plurality of embodiments (examples or variations) disclosed in the present specification.

A semiconductor light-emitting element according to an embodiment includes a semiconductor substrate, an epitaxial layered structure formed on the semiconductor substrate, including an N-type cladding layer, an active layer, and a P-type cladding layer, and made of an AlGaInP-based material, and an anti-reflection (AR) film including a first layer containing alumina ($Al_2O_3$) formed on an emission side end surface of the epitaxial layered structure, and a second layer formed on the first layer. A rare gas element content of the first layer is larger than a rare gas element content of the second layer.

In this configuration, the AR film has a multilayer structure including a first layer and a second layer. AlGaInP is weak against oxidation, but $Al_2O_3$ constituting the first layer traps oxygen, so that AlGaInP can be protected from oxidation. On the other hand, as can be seen from the fact that amorphous $Al_2O_3$ is used as a material of a porous ceramic, the density of $Al_2O_3$ is reduced depending on manufacturing conditions or the like, and $Al_2O_3$ may have a property of easily permeating water. Then, long-term reliability of AlGaInP cannot be secured. By intentionally containing the rare gas element in $Al_2O_3$, a dense film can be formed, which can prevent permeation of water.

In one embodiment, the rare gas element may be argon (Ar).

In one embodiment, the reflectance of the emission side end surface may be 0.2% or less at the same wavelength as the peak wavelength of emitted light.

In one embodiment, the rare gas element content in the first layer may be 0.2at% or more. Thus, a denser film can be formed. When the rare gas element content exceeds 5at%, a crystal state itself of the material constituting the film collapses to the contrary, and it becomes difficult to form the dense film. Thus, the rare gas element content in the first layer is desirably 5at% or less.

In one embodiment, the rare gas element content in the second layer may be less than 0.2at%.

In one embodiment, a film thickness $d_1$ of the first layer may satisfy $d_1 \leq \lambda_P/(2n_1)$ where $\lambda_P$ is an emission peak wavelength of the semiconductor light-emitting element, and $n_1$ is a refractive index of the first layer.

In one embodiment, the film thickness $d_1$ of the first layer may satisfy $d_1 \leq \lambda_P/(4n_1)$ where $\lambda_P$ is an emission peak wavelength of the semiconductor light-emitting element, and $n_1$ is a refractive index of the first layer, and a film thickness $d_2$ of the second layer may satisfy $d_2 \leq \lambda_P/(4n_2)$ where $n_2$ is a refractive index of the second layer.

In one embodiment, the film thickness $d_1$ of the first layer and the film thickness $d_2$ of the second layer may satisfy $d_1 > d_2$.

In one embodiment, the film thickness $d_1$ of the first layer may satisfy $d_1 > 5$ nm.

An external resonator type laser module according to an embodiment includes the semiconductor light-emitting element according to any one of the above and a grating element.

### Embodiment

Hereinafter, the present disclosure will be described based on a preferred embodiment with reference to the drawings. The same or equivalent components, members, and processing illustrated in the drawings are denoted by the same reference numerals, and redundant description will be omitted as appropriate. In addition, the exemplary embodiment is not intended to limit the disclosure, but is merely an example, and all features described in the exemplary embodiment and combinations thereof are not necessarily essential to the disclosure.

Dimensions (thickness, length, width, and the like) of each member described in the drawings may be enlarged or reduced for easy understanding as appropriate. Furthermore, the dimensions of the plurality of members do not necessarily indicate the magnitude relationship therebetween, and even if a certain member A is drawn thicker than another member B in the drawing, the member A may be thinner than the member B.

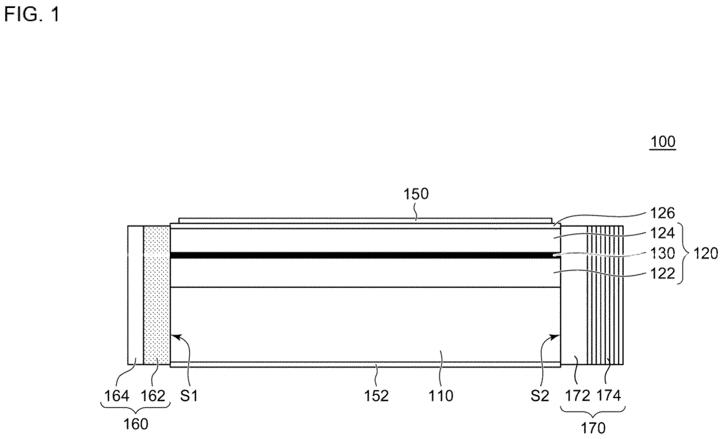

Fig. 1 is a cross-sectional view of a semiconductor light-emitting element 100 according to a first embodiment. The semiconductor light-emitting element 100 is used as a light source or a gain medium of the external resonator type laser module. The semiconductor light-emitting element 100 includes a semiconductor substrate 110, an epitaxial layered structure 120, a P-side electrode 150, an N-side electrode 152, an AR film 160, and an HR film 170.

The semiconductor substrate 110 is, for example, an N-type GaAs substrate. The epitaxial layered structure 120 is formed on the semiconductor substrate 110 by epitaxial growth. The epitaxial layered structure 120 includes an N-type cladding layer 122, an active layer 130, and a P-type cladding layer 124, and forms a waveguide. In the present embodiment, a P-type contact layer 126 made of GaAs is formed on the epitaxial layered structure 120 to enable contact with the electrode. A material of each layer of the epitaxial layered structure 120 is selected according to a desired wavelength, and in the present embodiment, an AlGaInP-based material is used. Note that the AlGaInP-based material in the present specification is a material that can be selected from materials represented by the general formula $(Al_{1-x}Ga_x)_yIn_{1-y}P$ ($0 \leq x \leq 1$, $0 \leq y \leq 1$), and collectively represents a two element material, a three element material, and a four element material. In the epitaxial layered structure 120, layers in contact with the AR film in a wide range are the N-type cladding layer and the P-type cladding layer that occupy most of the epitaxial layered structure, and these layers have a large influence on reliability. Thus, the epitaxial layered structure 120 of the AlGaInP-based material mainly refers to the N-type cladding layer and the P-type cladding layer. For example, the N-type cladding layer 122 is AlGaInP, the active layer 130 is GaInP, and the P-type cladding layer 124 is AlInP. The active layer is selected according to a desired wavelength, and may be GaInAsP.

The P-side electrode 150 is formed on the P-type contact layer 126, and the N-side electrode 152 is formed on a back surface of the semiconductor substrate 110.

When the semiconductor light-emitting element 100 is incorporated in the external resonator type laser module, the AR film 160 is formed on an end surface (emission side end surface, front end surface) S1 on the emission side.

The AR film 160 includes two layers, and includes a first layer 162 and a second layer 164. The first layer 162 is made of alumina ($Al_2O_3$) as a main material on the emission side end surface S1. The first layer 162 is formed such that a rare gas element is mixed in amorphous $Al_2O_3$. The rare gas element is specifically helium (He), argon (Ar), neon (Ne), krypton (Kr), xenon (Xe), or radon (Rn), but Ar is suitable from the viewpoint of affinity with a semiconductor manufacturing process.

The film thickness $d_1$ of the first layer 162 serving as a crystal protection layer is preferably from 5 nm to 120 nm. When the film thickness $d_1$ is 5 nm or less, a uniform film cannot be formed, the surface cannot be sufficiently terminated, and ingress of moisture from the outside cannot be prevented. When the film thickness $d_1$ is too thick, a band (wavelength range) in which the reflectance of the AR film is reduced is narrow, and it is extremely difficult to control a film thickness of a reflectance adjustment layer in a case where desired reflectance is to be obtained.

The second layer 164 is formed on the first layer 162. The second layer 164 may be made of an insulator material other than $Al_2O_3$, and preferably made of an insulator material having high stability in air, such as AlN or SiN.

With respect to the second layer 164 serving as the reflectance adjustment layer, when there is a refractive index variation due to incorporation of the rare gas element, an optical film thickness represented by a product of the refractive index and the film thickness varies. Thus, even when film formation can be performed with an accurate film thickness, the optical film thickness deviates from an optimum value, so that the reflectance cannot be sufficiently reduced. Thus, it is preferable to reduce the rare gas element content of the reflectance adjustment layer as much as possible.

That is, in the present embodiment, the rare gas element content of the first layer 162 is configured to be larger than the rare gas element content of the second layer 164. More specifically, the rare gas element content of the first layer 162 is preferably 0.2at% or more and 5at% or less.

For example, the first layer 162 can be formed by a sputtering method, and in this case, a desired amount of the rare gas element can be mixed into $Al_2O_3$ by adjusting the concentration of a sputtering atmosphere gas.

There is also a report that, in a normal semiconductor laser element, when the rare gas element content increases, heat is generated by light absorption by the rare gas element, and the element is deteriorated by COD (JP 4621791 B2). On the other hand, in the semiconductor light-emitting element to which the AR coating having an end surface reflectance of 1% or less is applied, an amount of light reflected by the emission surface and returning to the inside of the element is extremely small, and thus a light density at the emission side end surface decreases, and heat generation due to light absorption does not become a main problem. On the other hand, in an AR coated element, when the reflectance increases for some reason with long-term use, a residual reflectance loss on the element front end surface increases in use in a light source for the external resonator or the like. Thus, when the reflectance increases by a certain amount or more, a failure may occur. The failure of such a mode is also caused by alteration of the crystal at the end surface portion of the semiconductor crystal due to diffusion of moisture from the outside. In the AR coated element designed to have the lowest reflectance in the initial state, the reflectance increases when the refractive index changes due to the alteration of the crystal.

In the present embodiment, by coating the outermost surface of the semiconductor crystal with the dense crystal protection layer, moisture that permeates to the crystal end surface through the end surface film during operation can be suppressed, so that such a failure mode can be suppressed. Thus, the crystal protection layer in contact with the semiconductor crystal is preferably a dense film containing a certain amount or more of Ar, and the Ar concentration in the film is desirably 0.2at% or more. On the other hand, when the Ar concentration is too high, the crystalline state itself of the material for forming the crystal protection layer collapses, and a dense film cannot be formed to the contrary. Thus, the Ar concentration is desirably 5at% or less.

On the other hand, the rare gas element content in the second layer 164 is 0.2at% or less, more preferably 0.1at% or less. The rare gas element content here is a concept including 0, and the second layer 164 need not contain the rare gas element.

The first layer 162 functions as a protection layer for the epitaxial layered structure 120 which is the AlGaInP-based material. On the other hand, the second layer 164 has a function as the reflectance adjustment layer that adjusts the reflectance of the AR film 160 as a whole. Thus, the film thickness of the second layer 164 needs to be controlled with high accuracy so as to minimize the reflectance, and is preferably formed using a vapor deposition method. More preferably, the film thickness is preferably controlled so as to minimize the intensity of the emitted light while monitoring the light emitted from the emission side end surface S1 in-situ in a state where power is supplied to the semiconductor light-emitting element 100 to cause the semiconductor light-emitting element 100 to emit light during film formation of the second layer 164.

When the semiconductor light-emitting element 100 is incorporated in the external resonator type laser module, the high-reflection (HR) film 170 is formed on an end surface (rear end surface) S2 on the opposite to the emission side. The structure of the HR film 170 is not particularly limited, and a known technique may be used. A two-layer structure of a first layer 172 and a second layer 174 may be adopted. The first layer 172 may have a function as a protection layer. The second layer 174 is, for example, a dielectric multilayer film, and the number of layers and the thickness of each layer are controlled so as to obtain high reflectance at the oscillation wavelength of the laser.

The above is the configuration of the semiconductor light-emitting element 100.

In the present embodiment, the AR film 160 has the multilayer structure including the first layer 162 and the second layer 164. The AlGaInP-based material is weak against oxidation, but Al in $Al_2O_3$ constituting the first layer 162 traps oxygen, so that AlGaInP can be protected from oxidation.

On the other hand, as can be seen from the fact that $Al_2O_3$ is used as a material for ceramic, $Al_2O_3$ has a property of easily permeating water, and cannot secure the long-term reliability of AlGaInP as it is. In the present embodiment, by intentionally containing the rare gas element in $Al_2O_3$, a dense $Al_2O_3$ film can be formed, which can prevent permeation of water. In particular, a film formed by the sputtering method using the rare gas element has high adhesion to the crystal and is dense. As a result, defects present on the surface of the semiconductor crystal are terminated, and deterioration originating from the defects is suppressed, and in addition, permeation of moisture from the outside is suppressed, and thus the alteration of the crystal can be suppressed, and deterioration of long-term reliability can be suppressed.

Then, by controlling the film thickness of the second layer 164 with high accuracy in the order of 1 nm or less, reflectance of 0.2% or less, more preferably 0.1% or less can be achieved at a wavelength in a 600 nm band to a 700 nm band. When the second layer 164 contains the rare gas element, the refractive index of the film itself deviates from a theoretical value. The end surface film can effectively reduce the reflectance by designing the optical film thickness, which is the product of the refractive index and the film thickness, to be λ/4. However, when the refractive index of the second layer 164 varies due to mixing of the rare gas element, the optical film thickness, which is the product of the refractive index and the film thickness, changes, and deviation from a calculated value occurs. Thus, in order to improve controllability of the reflectance, the variation of the refractive index needs to be suppressed and film formation of a material having a stable refractive index needs to be performed. In the present embodiment, the rare gas element content in the second layer 164 serving as the reflectance adjustment layer is intentionally made smaller than that in the first layer 162 serving as the crystal protection layer. As a result, by suppressing the refractive index variation caused by the rare gas element and by performing film formation with a predetermined film thickness, desired reflectance can be stably obtained, and good AR coating characteristics can be obtained.

As described above, according to the present embodiment, the semiconductor light-emitting element 100 including the AR film 160 having long-term reliability and low reflectance can be provided.

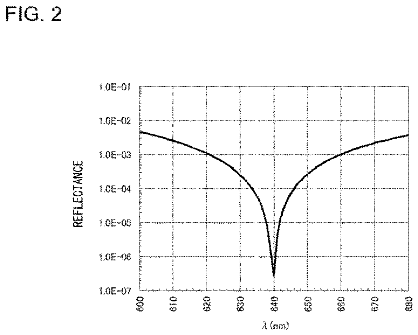

Fig. 2 is a diagram illustrating reflectance characteristics of the AR film 160 according to the first embodiment; In the AlGaInP-based material, a refractive index $n_s$ of the waveguide has a value between 3.0 to 3.6 depending on a composition of the AlGaInP-based material. Now, the refractive index $n_s$ of the waveguide is considered as 3.3. The first layer 162 serving as the crystal protection layer is made of $Al_2O_3$ having a refractive index $n_1 = 1.75$, and the second layer 164 serving as the reflectance adjustment layer is made of AlN having a refractive index $n_2 = 2.17$.

The film thickness $d_1$ of the first layer 162 preferably satisfies $d_1 \leq \lambda_P/(2n_1)$ where the emission peak wavelength of the semiconductor light-emitting element is $\lambda_P$.

Furthermore, in a case where the AR film 160 has a two-layer structure of the first layer 162 and the second layer 164, the film thickness $d_1$ of the first layer preferably satisfies $d_1 \leq \lambda_P/(4n_1)$, and the film thickness

$d_2$ of the second layer preferably satisfies $d_2 \leq \lambda_P/(4n_2)$.

The film thickness of the first layer 162 is $d_1 = 62.2$ nm, and the film thickness of the second layer 164 is $d_2 = 17.2$ nm. In the relationship between the refractive indexes at this time,

$$n_1 < \sqrt{n_s} < n_2$$

is established.

According to this AR film, reflectance of $10^{-6}$ or less is obtained at a wavelength of 640 nm.

Embodiment 2

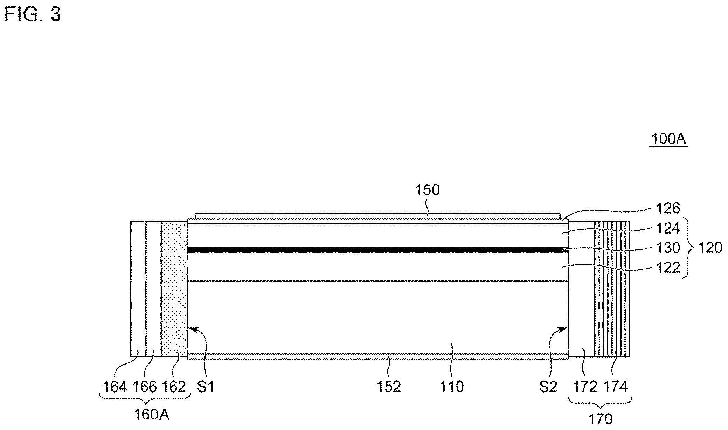

Fig. 3 is a cross-sectional view of a semiconductor light-emitting element 100A according to a second embodiment. In the semiconductor light-emitting element 100A, an AR film 160A has a three-layer structure, and specifically includes, in addition to the first layer 162 and the second layer 164, an intermediate layer 166 inserted therebetween.

The first layer 162 is $Al_2O_3$ as described above, and AIN can be selected as the second layer 164. Similarly to the first layer 162, $Al_2O_3$ can be selected as the intermediate layer 166, but a refractive index $n_3$ of the intermediate layer 166 is different from the refractive index $n_2$ of the first layer 162.

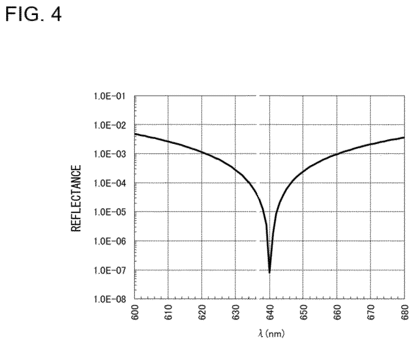

Fig. 4 is a diagram illustrating reflectance characteristics of the AR film 160A according to the second embodiment; The calculation was performed under the following conditions.

Refractive index $n_s$ of waveguide = 3.3

First layer 162: material $Al_2O_3$, refractive index $n_1 = 1.75$, film thickness $d_1 = 39.3$ nm

Intermediate layer 166: material $Al_2O_3$, refractive index $n_3 = 1.70$, film thickness $d_3 = 20.2$ nm

Second layer 164: material AIN, refractive index $n_2 = 2.17$, film thickness $d_2 = 19.5$ nm

Also in this case, similarly, reflectance of $10^{-6}$ or less is obtained at 640 nm.

Embodiment 3

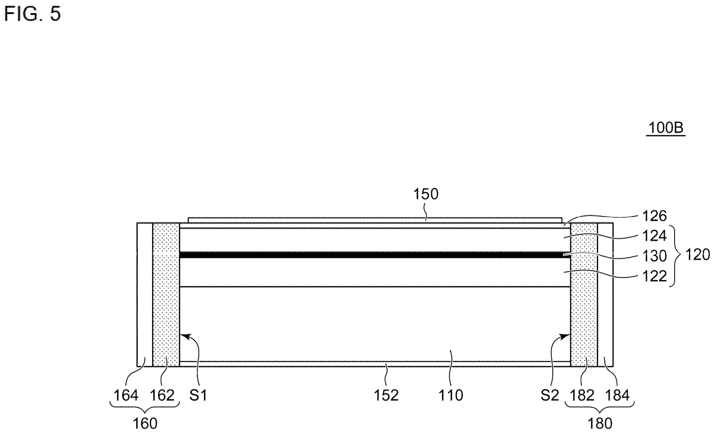

Fig. 5 is a cross-sectional view of a semiconductor light-emitting element 100B according to a third embodiment. In the semiconductor light-emitting element 100B, an AR film 180 is also formed on a rear end surface S2. The AR film 180 is similar to the AR film 160, that is, a two-layer structure of a first layer 182 and a second layer 184 may be adopted. The first layer 182 may have a function as the crystal protection layer. The second layer 184 may have a function as the reflectance adjustment layer. The second layer 184 is made of, for example, an insulator material or a dielectric multilayer film, and is adjusted so as to obtain low reflectance with respect to the oscillation wavelength of the laser.

Laser Module

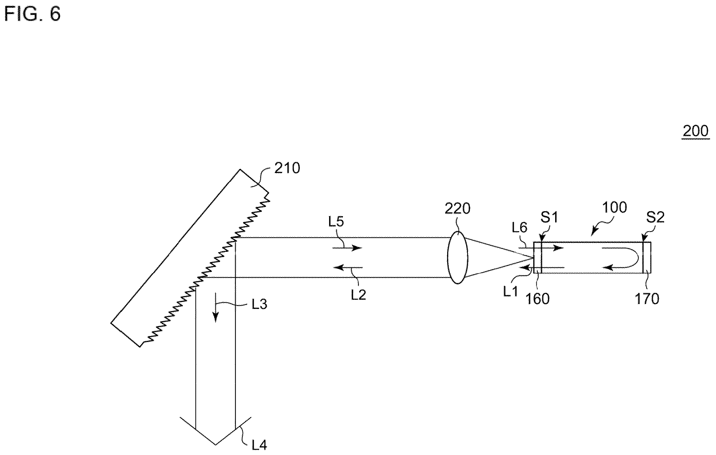

The semiconductor light-emitting elements 100, 100A and 100B (hereinafter, collectively referred to as 100) are incorporated in the external resonator type laser module. Fig. 6 is a view illustrating an external resonator type laser module 200 including the semiconductor light-emitting element 100.

The laser module 200 includes the semiconductor light-emitting element 100, a grating element 210, and a lens 220. In the laser module 200, a resonator is configured between an HR film 170 of the semiconductor light-emitting element 100 and the grating element 210. Light L1 emitted from the emission side end surface S1 of the semiconductor light-emitting element 100 is collimated by the lens 220, and the collimated light L2 is incident on the grating element 210. 0th-order diffracted light L3 of the grating element 210 is extracted to the outside as emitted light L4 of the laser module 200. First-order diffracted light L5 of the grating element 210 is condensed by the lens 220 and is incident on a waveguide inside the semiconductor light-emitting element 100 from the emission side end surface S1 of the semiconductor light-emitting element 100. Light L6 incident on the waveguide of the semiconductor light-emitting element 100 is amplified in the semiconductor light-emitting element 100 and totally reflected by the HR film 170.

In the laser module 200 including the semiconductor light-emitting element 100B described in the third embodiment, a reflection optical system such as a grating or a mirror is also disposed on the rear end surface side.

REFERENCE SIGNS LIST

| | |
|---|---|
| 100 | Semiconductor light-emitting element |
| 110 | Semiconductor substrate |
| 120 | epitaxial layered structure |
| 122 | N-type cladding layer |
| 124 | P-type cladding layer |
| 126 | P-type contact layer |
| 130 | Active layer |
| 150 | P-side electrode |
| 152 | N-side electrode |
| 160 | AR film |
| 162 | First layer |
| 164 | Second layer |
| 166 | Intermediate layer |
| 170 | HR film |
| 172 | First layer |
| 174 | Second layer |
| 180 | AR film |
| 182 | First layer |
| 184 | Second layer |
| 200 | Laser module |
| 210 | Grating element |
| 220 | Lens |

**Claims**

1. A semiconductor light-emitting element (100) comprising:

    a semiconductor substrate (110);
    an epitaxial layered structure (120) formed on the semiconductor substrate (110), including an N-type cladding layer (122), an active layer (130), and a P-type cladding layer (124), and made of an AlGaInP-based material; and
    an anti-reflection (AR) film (160) including a first layer (162) containing $Al_2O_3$ formed on an emission side end surface (S1) of the epitaxial layered structure (120), and a second layer (164) formed on the first layer (162), **characterised in that**
    a rare gas element content of the first layer (162) is larger than a rare gas element content of the second layer (164).

2. The semiconductor light-emitting element (100) according to claim 1, wherein reflectance of the emission side end surface (S1) is 0.2% or less at the same wavelength as a peak wavelength of emitted light.

3. The semiconductor light-emitting element (100) according to claim 1 or 2, wherein the rare gas element content in the first layer (162) is 0.2at% or more and 5at% or less.

4. The semiconductor light-emitting element (100) according to claim 1 or 2, wherein the rare gas element content in the second layer (164) is less than 0.2at%.

5. The semiconductor light-emitting element (100) according to claim 2, wherein a film thickness $d_1$ of the first layer (162) satisfies $d_1 \leq \lambda_P/(2n_1)$, where $\lambda_P$ is an emission peak wavelength of the semiconductor light-emitting element (100), and $n_1$ is a refractive index of the first layer (162).

6. The semiconductor light-emitting element (100) according to claim 1, wherein

    a film thickness $d_1$ of the first layer (162) satisfies $d_1 \leq \lambda_P/(4n_1)$, where $\lambda_P$ is an emission peak wavelength of the semiconductor light-emitting element (100), and $n_1$ is a refractive index of the first layer (162), and
    a film thickness $d_2$ of the second layer (164) satisfies $d_2 \leq \lambda_P/(4n_2)$, where $n_2$ is a refractive index of the second layer (164).

7. The semiconductor light-emitting element (100) according to claim 6, wherein the film thickness $d_1$ of the first layer (162) and the film thickness $d_2$ of the second layer (164) satisfy $d_1 > d_2$.

8. The semiconductor light-emitting element (100) according to claim 1 or 2, wherein a film thickness $d_1$ of the first layer (162) satisfies $d_1 > 5$ nm.

9. An external resonator type laser module (200) comprising:
   the semiconductor light-emitting element (100) according to any one of claims 1 to 8; and a grating element (210).

**Patentansprüche**

1. Halbleiter-Lichtemissionselement (100), umfassend:

    ein Halbleitersubstrat (110),
    eine auf dem Halbleitersubstrat (110) ausgebildete Epitaxialschichtstruktur (120), die eine N-Typ-Mantelschicht (122), eine aktive Schicht (130) und eine P-Typ-Mantelschicht (124) umfasst und aus einem Material auf AlGaInP-Basis besteht, und
    einen Antireflexionsfilm (AR) (160) mit einer ersten Schicht (162), die $Al_2O_3$ enthält und auf einer emissionsseitigen Endfläche (S1) der Epitaxialschichtstruktur (120) ausgebildet ist, und einer zweiten Schicht (164), die auf der ersten Schicht (162) ausgebildet ist,
    **dadurch gekennzeichnet, dass**
    ein Edelgaselementgehalt der ersten Schicht (162) größer ist als ein Edelgaselementgehalt der zweiten Schicht (164).

2. Halbleiter-Lichtemissionselement (100) nach Anspruch 1, wobei der Reflexionsgrad der emissionsseitigen Endfläche (S1) bei derselben Wellenlänge wie die Spitzenwellenlänge des emittierten Lichts 0,2 % oder weniger beträgt.

3. Halbleiter-Lichtemissionselement (100) nach Anspruch 1 oder 2, wobei der Edelgaselementgehalt in der ersten Schicht (162) 0,2 at% oder mehr und 5 at% oder weniger beträgt.

4. Halbleiter-Lichtemissionselement (100) nach Anspruch 1 oder 2, wobei der Edelgaselementgehalt in der zweiten Schicht (164) weniger als 0,2 at% beträgt.

5. Halbleiter-Lichtemissionselement (100) nach Anspruch 2, wobei eine Schichtdicke $d_1$ der ersten Schicht (162) $d_1 \leq \lambda_P/(2n_1)$ erfüllt, wobei $\lambda_P$ eine Emissionsspitzenwellenlänge des Halbleiter-Lichtemissionselements (100) ist und $n_1$ ein Brechungsindex der ersten Schicht (162) ist.

6. Halbleiter-Lichtemissionselement (100) nach Anspruch 1, wobei

eine Schichtdicke $d_1$ der ersten Schicht (162) $d_1 \leq \lambda_P /(4n_1)$ erfüllt, wobei $\lambda_P$ eine Emissionsspitzenwellenlänge des Halbleiter-Lichtemissionselements (100) ist und $n_1$ ein Brechungsindex der ersten Schicht (162) ist, und

eine Filmdicke $d_2$ der zweiten Schicht (164) $d_2 \leq \lambda_P /(4n_2)$ erfüllt, wobei $n_2$ ein Brechungsindex der zweiten Schicht (164) ist.

7. Halbleiter-Lichtemissionselement (100) nach Anspruch 6, wobei die Schichtdicke $d_1$ der ersten Schicht (162) und die Schichtdicke $d_2$ der zweiten Schicht (164) $d_1 > d_2$ erfüllen.

8. Halbleiter-Lichtemissionselement (100) gemäß Anspruch 1 oder 2, wobei eine Schichtdicke $d_1$ der ersten Schicht (162) $d_1 > 5$ nm erfüllt.

9. Laser-Modul (200) vom Typ mit externem Resonator, umfassend das Halbleiter-Lichtemissionselement (100) gemäß einem der Ansprüche 1 bis 8 und ein Gitterelement (210).

**Revendications**

1. Élément électroluminescent à semi-conducteur (100) comprenant :

un substrat semi-conducteur (110) ;
une structure épitaxiale en couches (120) formée sur le substrat semi-conducteur (110), comportant une couche de gainage de type N (122), une couche active (130), et une couche de gainage de type P (124), et constituée d'un matériau à base d'AlGaInP ; et
un film antireflet (AR) (160) comportant une première couche (162) contenant de l'$Al_2O_3$ formée sur une surface d'extrémité côté émission (S1) de la structure épitaxiale en couches (120), et une seconde couche (164) formée sur la première couche (162),
**caractérisé en ce que**
une teneur en élément de gaz rare de la première couche (162) est supérieure à une teneur en élément de gaz rare de la seconde couche (164).

2. Élément électroluminescent à semi-conducteur (100) selon la revendication 1, dans lequel un facteur de réflexion de la surface d'extrémité côté émission (S1) est de 0,2 % ou moins à la même longueur d'onde qu'une longueur d'onde de crête de la lumière émise.

3. Élément électroluminescent à semi-conducteur (100) selon la revendication 1 ou 2, dans lequel la teneur en élément de gaz rare dans la première couche (162) est de 0,2 % en atomes ou plus et de 5 % en atomes ou moins.

4. Élément électroluminescent à semi-conducteur (100) selon la revendication 1 ou 2, dans lequel la teneur en élément de gaz rare dans la seconde couche (164) est inférieure à 0,2 % en atomes.

5. Élément électroluminescent à semi-conducteur (100) selon la revendication 2, dans lequel une épaisseur de film $d_1$ de la première couche (162) satisfait à $d_1 \leq \lambda_p/(2n_1)$, où $\lambda_p$ est une longueur d'onde de crête d'émission de l'élément électroluminescent à semi-conducteur (100), et $n_1$ est un indice de réfraction de la première couche (162).

6. Élément électroluminescent à semi-conducteur (100) selon la revendication 1, dans lequel

une épaisseur de film $d_1$ de la première couche (162) satisfait à $d_1 \leq \lambda_p/(4n_1)$, où $\lambda_p$ est une longueur d'onde de crête d'émission de l'élément électroluminescent à semi-conducteur (100), et $n_1$ est un indice de réfraction de la première couche (162), et
une épaisseur de film $d_2$ de la seconde couche (164) satisfait à $d_2 \leq \lambda_p/(4n_2)$, où $n_2$ est un indice de réfraction de la seconde couche (164).

7. Élément électroluminescent à semi-conducteur (100) selon la revendication 6, dans lequel l'épaisseur de film $d_1$ de la première couche (162) et l'épaisseur de film $d_2$ de la seconde couche (164) satisfont à $d_1 > d_2$.

8. Élément électroluminescent à semi-conducteur (100) selon la revendication 1 ou 2, dans lequel une épaisseur de film $d_1$ de la première couche (162) satisfait à $d_1 > 5$ nm.

9. Module laser de type résonateur externe (200) comprenant :

l'élément électroluminescent à semi-conducteur (100) selon l'une quelconque des revendications 1 à 8 ; et
un élément de réseau (210).

EP 4 492 592 B1

FIG. 1

FIG. 2

FIG. 3

100A

126
124
130
122
} 120

172 174
} 170

S2

150

110

152

S1

164 166 162
160A

FIG. 4

EP 4 492 592 B1

FIG. 5

FIG. 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H6125149 A
- US 6297066 B
- JP H4299591 A
- JP 4621791 B
- US 2005127383 A1